Europäisches Patentamt

European Patent Office

Office européen des brevets

(11) Publication number: **0 212 267**
A1

## (12) EUROPEAN PATENT APPLICATION

(21) Application number: 86109814.3

(22) Date of filing: 17.07.86

(51) Int. Cl.⁴: **H 01 L 29/86**, H 03 H 11/24

(30) Priority: 12.08.85 US 764367

(43) Date of publication of application: 04.03.87 Bulletin 87/10

(84) Designated Contracting States: DE FR IT NL

(71) Applicant: MOTOROLA, INC., 1303 East Algonquin Road, Schaumburg, Illinois 60196 (US)

(72) Inventor: Stanley, Michael E., 3707 E. Dewberry, Mesa Arizona 85206 (US)

(74) Representative: Ibbotson, Harold et al, Motorola Ltd Jays Close Viables Industrial Estate, Basingstoke Hants RG22 4PD (GB)

(54) Improved differential input attenuator circuit.

(57) A diode is formed in an isolated epitaxial (epi) region of a monolithic integrated circuit and connected to the operating potential applied thereto. The monolithic circuit includes a resistor formed in the isolated epi region which is connected to the input of the monolithic circuit. The operating potential applied through the diode raises the otherwise floating epi region to a voltage slightly less than the operating potential of the monolithic circuit thereby reducing the parasitic capacitance associated with the resistor-to-epi junction and the epi-to-substrate junction of the monolithic circuit. This reduction of parasitic capacitance improves the time response of the monolithic circuit.

## IMPROVED DIFFERENTIAL INPUT ATTENUATOR CIRCUIT

### Background of the Invention

The present invention relates to differential input attenuator circuits for use in data transmission line receivers. More particularly, the present invention relates to an improved differential input attenuator circuit comprising diffused resistors contained within a "floating" epitaxial tub wherein the parasitic capacitance associated with said resistors and said "floating" epitaxial tub is reduced and the time response is thereby improved.

Data transmission line receivers for use in EIA RS422/485 applications are well known. Typically, a line receiver is operated from a single power supply to receive the transmission of digital data on a differential, balanced twisted-pair transmission line. The line receiver generally includes a differential amplifier having a pair of inputs coupled to inputs of the line receiver through an attenuation circuit.

The attenuation circuit of the line receiver in some cases is implemented on an integrated circuit by utilizing diffused resistors that are placed in isolated epitaxial regions. Since each of these diffused resistors comprises a p region which is adjacent to the n material of the isolated epitaxial region, there are formed p-n junctions each of which has an associated parasitic capacitance.

In addition there is formed a p-n junction between the n material of the isolated epitaxial region and the underlying p material substrate which also has an associated parasitic capacitance.

This parasitic capacitance increases the propagation delay of the attenuation circuit and the line receiver in which it is used.

Hence, there arises a need to reduce the parasitic capacitance associated with the p-n junctions formed between the diffused resistors and an isolated epitaxial region as well as the parasitic capacitance associated with the p-n junction formed between the isolated epitaxial region and the underlying substrate.

## Summary of the Invention.

Accordingly it is an object of the present invention to provide an improved differential input attenuator circuit with reduced parasitic capacitance.

Another object of the invention is to provide a differential input attenuator circuit with reduced propagation delay.

In accordance with the above and other objects, there is provided a circuit for improving a differential input attenuator circuit comprising a diode connected from the positive supply voltage of the differential input attenuator circuit to the isolated epitaxial region in which the diffused resistors of the differential input attenuator circuit are formed.

For some input voltages this connection increases the reverse bias of the diffused resistor-to-epitaxial region and epitaxial region-to-substrate junctions thereby increasing the depletion region width of each junction and decreasing the associated junction capacitance.

## Brief Description of the Drawings

FIG. 1 is a schematic illustrating a known differential input attenuator circuit.

FIG. 2 is a cross-sectional view of a portion of the monolithic circuit of FIG. 1.

FIG. 3 is a schematic illustrating the parasitic capacitance associated with some of the resistors of the circuit of FIG. 1 as well as a parasitic epi-to-substrate diode and the diode of the present invention.

FIG. 4 is a cross-section view of a portion of the monolithic circuit of FIG. 3.

Detailed Description of the Preferred Embodiment

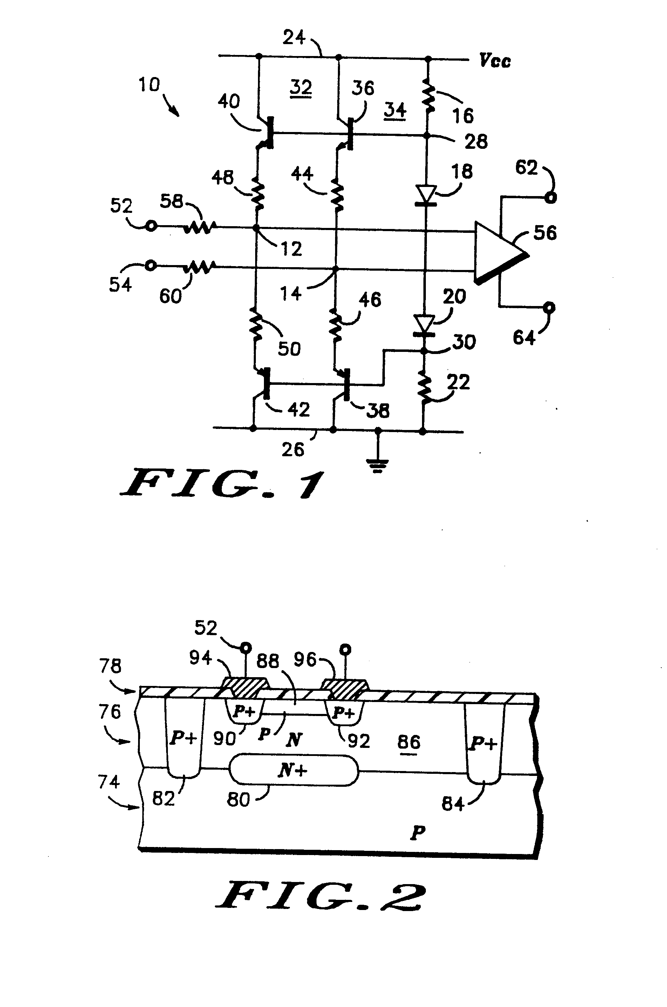

Turning to FIG. 1 there is shown a differential input attenuator integrated circuit (IC) 10 which is suited to be manufactured in monolithic integrated circuit form such as a portion of Motorola Part No. MC75173. Normally resistor 58 equals resistor 60 and resistors 44, 46 48 and 50 are equal to each other. This portion of the circuit basically functions as a voltage divider over most of the operating range of the circuit, with the gain equal to R48/(R48+R58) where R48 and R58 are the respective resistance values of resistor 48 and resistor 58.

A bias circuit including resistor 16, diode 18, diode 20 and resistor 22 connected in series in the order mentioned between first and second power supply conductors 24 and 26 produces first and second bias signals at output nodes 28 and 30. By matching of the circuit elements of the bias circuit, the center point between diodes 18 and 20 is at a voltage level determined by the relative values of resistors 16 and 22. Thus, the bias signals appearing at the outputs 28 and 30 are at a known voltage level.

A pair of transistor circuits 32 and 34 are coupled between the power supply conductors to the outputs 28 and 30 of the bias circuit which establishes the voltage levels appearing at nodes 12 and 14. Each of the transistor circuits includes a pair of transistors 36, 38: 40, 42 respectively having the emitters thereof interconnected through respective series connected resistors 44, 46: 48, 50. The collectors of each pair of transistors are connected between the respective power supply conductors with output nodes 12 and 14 being connected between the series connected resistors of the particular transistor circuit. The base electrodes of transistors 36 and 40 are connected to output 28 of the bias circuit. Likewise, the base electrodes of transistors 38 and 42 are connected to output 30 of the bias circuit. Resistors 44, 46, 48 and 50 are matched and are of equal resistance value. Resistors 58 and 60 are normally constructed within an isolated epitaxial region whose potential is allowed to float with respect to the supply voltage $V_{CC}$. Resistors 58 and 60 must be contained in such a region because the input voltage at 52 and 54 could exceed $V_{CC}$ and thereby forward bias the resistor-to-epi junctions if standard epi contacts were used. In practice resistors 44, 46, 48 and 50 may also be contained in this "floating" epi tub.

To illustrate the parasitic capacitance associated with this "floating" epi tub, a cross-sectional view of a portion of IC 10 is illustrated in FIG. 2. As shown, IC 10 is comprised of a substrate 74 which is formed of a first or P-type semiconductor material. An epitaxial or epi layer 76 is then formed onto substrate 74. The epi layer is of a second or N-type semiconductor material. A dielectric layer 78 having selective openings formed therein is disposed onto the upper surface of epi layer 76. Also, during the fabrication process, buried layer 80 of N+ type semiconductor material may be formed between epi layer 76 and substrate 74. During fabrication P+ isolation regions are selectively formed through the epi layer to isolate different epi regions or tubs from each other as is known. For instance, isolation regions 82 and 84 provide an isolated epi tub 86 within epi layer 76. Resistor 58 is then formed by a P-type region 88 within isolated tub 86 and is disposed between P+ type regions 90 and 92. Conductive metal layers are selectively deposited onto dielectric layer 78 to form circuit connections as required. Input terminal 52, for example, is thereby connected through a metal run which includes metal layer 94 connected to resistor 58 through P+ region 90. Similarly, the distal end of resistor 58 (region 88) is coupled through P+ region 92 and metal layer 96 to an input to amplifier 56. It is to be understood that resistors 44, 46, 48, 50 and 60 are similarly formed in isolated epi tub 86 and the remaining elements of circuit 10 are formed in epi layer 76 in a known and conventional manner. The manufacturing steps and process for fabricating IC 10 are conventional and are known to those skilled in the art.

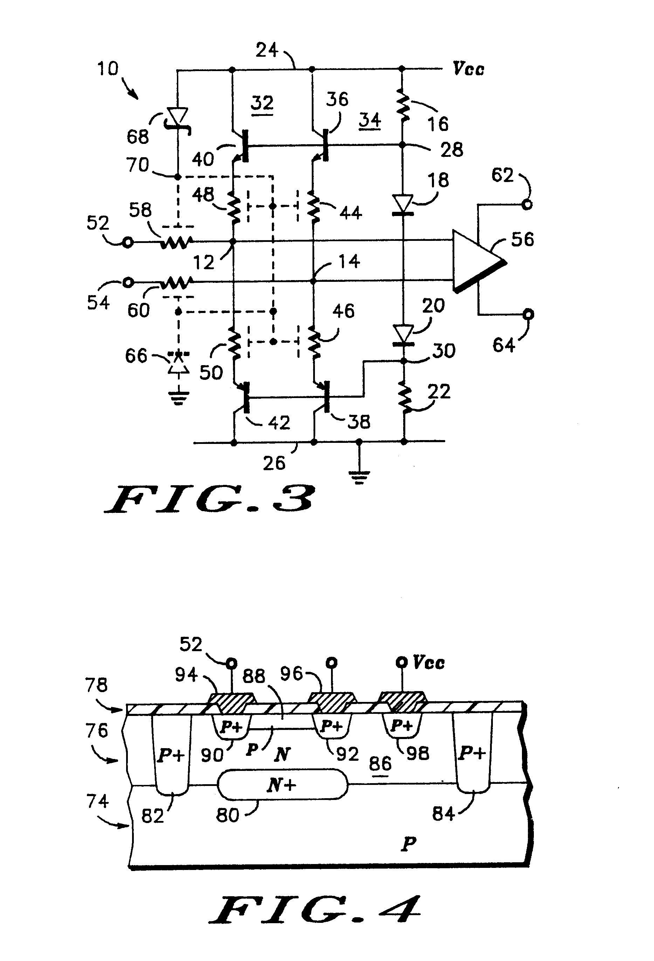

Each of resistors 44, 46, 48, 50, 58 and 60 has a corresponding resistor-to-epi junction with the epi tub and an associated parasitic capacitance. This parasitic capacitance is illustrated in FIG. 3 by the dashed straight lines adjacent to each of resistors 44, 46, 48, 50, 58 and 60.

Since all of these resistors are diffused into the same epi tub the parasitic capacitors are connected at node 70 which represents the isolated epi tub. There is also a parasitic epi-to-substrate junction formed between the isolated epi tub and the underlying substrate. This parasitic junction is illustrated as diode 66 in FIG. 3.

FIGS. 3 and 4 illustrate the improvement of the present invention which comprises diode 68 whose anode is connected to the positive supply voltage $V_{CC}$ and whose cathode is connected to node 70 or the epi tub in which resistors 44, 46, 48, 50, 58 and 60 are diffused. This diode may be merged into the epi tub 86 which contains resistors 44, 46, 48, 50, 58 and 60 as illustrated by P + region 98 of FIG. 4.

Without diode 68 the potential of the epi tub would float one Ø, or one diode drop, below the most positive side of any resistor 44, 46, 48, 50, 58 or 60. For input voltages below approximately $V_{cm}$, where:

$$V_{cm} = (V_{cc} - 2\emptyset) \times \frac{R22}{(R16+R22)} + \emptyset$$

$\emptyset$ = one diode drop

R22 = Resistance of resistor 22 in ohms

R16 = Resistance of resistor 16 in ohms

this epi tub voltage would be:

$$V_{epi} = V_{cm} - \emptyset$$

For input voltages above $V_{cm}$, the epi tub voltage would float at approximately $V_{in} - \emptyset$, where $V_{in}$ equals the input voltage at 52 or 54.

The addition of diode 68 biases the epi tub voltage to Vcc - V68 for input voltages less than approximately Vcc + $\emptyset$ - V68, where V68 is equal to the voltage drop across diode 68. For input voltages less than Vcc + $\emptyset$ - V68 the bias voltage supplied by diode 68 decreases the effects of parasitic diode 66 and decreases the resistor-to-epi junction capacitance of resistors 44, 46, 48, 50, 58 and 60.

The voltage supplied by diode 68 increases the reverse bias on the resistor-to-epi junctions which increases the depletion region width of each junction which decreases the parasitic capacitance associated with each junction.

A feature of the present invention is that diode 68 can be utilized in the attenuation input stage of a line receiver to reduce the parasitic capacitance of the resistors formed in the isolated epi tub and therefore reduce the propagation delay of the receiver. As illustrated, a typical line receiver includes a differential amplifier 56 having differential inputs coupled through an attenuation circuit comprising resistors 58 and 60 to inputs 52 and 54 of the line receiver. The differential amplifier 56 has outputs 62 and 64 which drive further stages of the receiver (not shown). For example, the MC75173 is a monolithic integrated line receiver circuit of the type referred to which is manufactured by Motorola, Inc. in which diode 68 can be utilized.

Since this parasitic capacitance is one of the factors that adversely affects the propagation delay time of this differential input attenuator circuit, the reduction of the parasitic capacitance results in improved performance as reflected by decreased propagation delay.

Hence, what has been described above is a novel improved differential input attenuator circuit which has reduced parasitic capacitance associated with the resistors diffused in the isolated epi tub and therefore has decreased propagation delay.

CLAIMS

1. In a monolithic integrated circuit formed by a substrate of a first semiconductor material of a first conductivity type, an epitaxial layer of a second semiconductor material of a second conductivity type, a plurality of regions of a semiconductor material of the first conductivity type formed in said epitaxial layer for isolating predetermined regions of the epitaxial layer from other of such predetermined regions, and including at least one resistor formed in a first one of said isolated epitaxial regions, conducting means for connecting the resistor between a first terminal at which is intended to be supplied an input signal and a first circuit node, and means for supplying an operating potential to the circuit, the improvement comprising a bias circuit for decreasing the parasitic capacitance associated with the junction between said resistor and said first isolated epitaxial region, further comprising:

a diode coupled from said operating potential means to said first isolated epitaxial region.

2. The circuit of claim 1 wherein said diode is imbedded in said first isolated epitaxial region.

3. The circuit of claim 2 wherein said diode is a Schottky diode.

4. A monolithic integrated circuit for providing a voltage offset between first and second terminals formed by a substrate of a first semiconductor material of a first conductivity type, an epitaxial layer of a second semiconductor material of a second conductivity type, a plurality of regions of a semiconductor material of a first conductivity type formed in said epitaxial layer for isolating predetermined regions of said epitaxial layer from other of such predetermined regions;

said circuit comprising first and second power supply conductors, first bias circuit means coupled between said first and second power supply conductors and having first and second outputs at which first and second bias signals are provided respectively;

first and second transistor circuit means each including a first transistor and a second transistor of different conductivity type than said first transistor, said first and second transistors each having first, second and control electrodes, said control electrodes of said first and second transistors being coupled respectively to said first and second outputs of said first bias circuit means, said first electrodes of said first and second transistors of said first transistor circuit means being coupled to the first terminal, said first electrode of said first and second transistor of said second transistor circuit means being coupled to the second terminal, said second electrodes of each of said first transistors being coupled to said first power supply conductor, and said second electrodes of each of said second transistors being coupled to said second power supply conductor;

and including at least one resistor formed in a first one of said isolated epitaxial regions, conducting means for connecting said resistor between a third terminal at which is intended to be supplied an input signal and said first terminal;

and second bias circuit means for decreasing the parasitic capacitance associated with the junction between said resistor and said first one of said isolated epitaxial regions, said second bias circuit means comprising a diode coupled from said first power supply conductor to said first one of said isolated epitaxial regions.

5. The circuit of claim 4 wherein said diode is embedded in said first one of said isolated epitaxial regions.

6.    The circuit of claim 5 wherein said diode is a
Schottky diode.

*FIG. 1*

*FIG. 2*

FIG.3

FIG.4

European Patent
Office

**EUROPEAN SEARCH REPORT**

0212267

Application number

EP 86 10 9814

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IBM TECHNICAL DISCLOSURE BULLETIN, vol. 21, no. 3, August 1978, page 943, New York, US; S.C. HENNESSEY: "Integrated circuit EPI bias current control with schottky contact" * Whole document * | 1-3 | H 01 L 29/86 H 03 H 11/24 |
| Y | Idem | 4-6 | |
| Y | TEXAS INSTRUMENTS, October 1980, pages 5-192-5-197, Bulletin no. DL-S 12770, Dallas, Texas, US: "Type SN 75173. Quadruple differential line receiver" * Page 5-192, left lower figure * | 4-6 | |
| X | FR-A-1 549 853 (IBM) * Figures 4,5; page 3, left-hand column, lines 1-25 * | 1,2 | TECHNICAL FIELDS SEARCHED (Int. Cl.4) |
| X | IBM TECHNICAL DISCLOSURE BULLETIN, vol. 13, no. 6, November 1970, page 1645, New York, US; B. AGUSTA: "DC bias for EPI pocket pulse applications" * Whole document * | 1,2 | H 01 L H 03 H H 03 F H 04 L |

The present search report has been drawn up for all claims

| Place of search | Date of completion of the search | Examiner |
|---|---|---|
| THE HAGUE | 10-11-1986 | CARDON A. |